(19) Europäisches Patentamt
European Patent Office
Office européen des brevets

(11) **EP 4 506 666 A1**

(12) **EUROPEAN PATENT APPLICATION**
published in accordance with Art. 153(4) EPC

(43) Date of publication:
**12.02.2025 Bulletin 2025/07**

(21) Application number: **23784576.3**

(22) Date of filing: **06.03.2023**

(51) International Patent Classification (IPC):
**G01J 1/02** (2006.01)   **G01J 1/04** (2006.01)
**H01L 27/146** (2006.01)   **H01L 31/0232** (2014.01)
**H01L 31/10** (2006.01)   **H05B 33/02** (2006.01)
**H10K 50/00** (2023.01)   **H10K 59/00** (2023.01)

(52) Cooperative Patent Classification (CPC):
**G01J 1/02; G01J 1/04; H05B 33/02; H10F 30/20;
H10F 39/12; H10F 77/40; H10K 50/00; H10K 59/00**

(86) International application number:
**PCT/JP2023/008238**

(87) International publication number:
**WO 2023/195283 (12.10.2023 Gazette 2023/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **04.04.2022 JP 2022062323**

(71) Applicant: **Sony Semiconductor Solutions
Corporation
Atsugi-shi, Kanagawa 243-0014 (JP)**

(72) Inventors:
• **TAKAHASHI, Seiki
Atsugi-shi, Kanagawa 243-0014 (JP)**

• **OGASAHARA, Takayuki
Atsugi-shi, Kanagawa 243-0014 (JP)**
• **YOKOCHI, Kaito
Atsugi-shi, Kanagawa 243-0014 (JP)**
• **MIYATA, Koji
Atsugi-shi, Kanagawa 243-0014 (JP)**
• **TAKASE, Hiroaki
Atsugi-shi, Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(54) **PHOTODETECTOR AND ELECTRONIC DEVICE**

(57)     A photodetection element according to the present disclosure includes a first photoelectric conversion unit, a second photoelectric conversion unit, a third photoelectric conversion unit, a color splitter layer (43), and an antireflection film (50). The first photoelectric conversion unit photoelectrically converts light in a first wavelength range. The second photoelectric conversion unit is arranged side by side with the first photoelectric conversion unit and photoelectrically converts light in a second wavelength range. The third photoelectric conversion unit is arranged side by side with the first photoelectric conversion unit and photoelectrically converts light in a third wavelength range. The color splitter layer (43) is arranged on a light incident side of the first photoelectric conversion unit, the second photoelectric conversion unit, and the third photoelectric conversion unit. The antireflection film (50) is arranged on a light incident side of the color splitter layer (43). The antireflection film (50) arranged on the light incident side of the first photoelectric conversion unit, the antireflection film (50) arranged on a light incident side of the second photoelectric conversion unit, and the antireflection film (50) arranged on a light incident side of the third photoelectric conversion unit have different respective configurations.

Processed by Luminess, 75001 PARIS (FR)

EP 4 506 666 A1

# FIG.3

**Description**

Field

The present disclosure relates to a photodetection element and an electronic device.

Background

In recent years, electronic devices such as digital cameras are becoming increasingly popular, and demands for photodetection elements such as image sensors, which are main components of the electronic devices, are increasing. Accordingly, technology development for achieving high image quality and high functionality of the photodetection element has been actively performed (see, for example, Patent Literature 1).

Citation List

Patent Literature

Patent Literature 1: JP 2021-140152 A

Summary

Technical Problem

However, in the above-described conventional technology, there is room for further improvement in terms of improving the sensitivity of the photodetection element.
Therefore, the present disclosure proposes a photodetection element and an electronic device capable of improving sensitivity. Solution to Problem
According to the present disclosure, there is provided a photodetection element. The photodetection element includes includes a first photoelectric conversion unit, a second photoelectric conversion unit, a third photoelectric conversion unit, a color splitter layer, and an antireflection film. The first photoelectric conversion unit photoelectrically converts light in a first wavelength range. The second photoelectric conversion unit is arranged side by side with the first photoelectric conversion unit and photoelectrically converts light in a second wavelength range different from the first wavelength range. The third photoelectric conversion unit is arranged side by side with the first photoelectric conversion unit and the second photoelectric conversion unit and photoelectrically converts light in a third wavelength range different from the first wavelength range and the second wavelength range. The color splitter layer is arranged on a light incident side of the first photoelectric conversion unit, the second photoelectric conversion unit, and the third photoelectric conversion unit. The antireflection film is arranged on a light incident side of the color splitter layer. Furthermore, the antireflection film arranged on the light incident side of the first photoelectric conversion unit, the antireflection film arranged on a light incident side of the second photoelectric conversion unit, and the antireflection film arranged on a light incident side of the third photoelectric conversion unit have different respective configurations.

Brief Description of Drawings

FIG. 1 is a system configuration diagram illustrating a schematic configuration example of a solid-state imaging element according to an embodiment of the present disclosure.
FIG. 2 is a plan view illustrating an example of a configuration of a pixel array unit according to an embodiment of the present disclosure.
FIG. 3 is a cross-sectional view taken along line A-A illustrated in FIG. 2 as viewed in a direction of arrows.
FIG. 4 is a cross-sectional view taken along line B-B illustrated in FIG. 2 as viewed in a direction of arrows.
FIG. 5 is a view for describing a principle of color splitters according to an embodiment of the present disclosure.
FIG. 6 is a view illustrating an incident state of incident light in the pixel array unit according to the embodiment of the present disclosure.
FIG. 7 is a view illustrating an incident state of incident light in the pixel array unit according to the embodiment of the present disclosure.
FIG. 8 is a view illustrating an incident state of incident light in the pixel array unit according to the embodiment of the present disclosure.

FIG. 9 is a view illustrating an incident state of incident light in the pixel array unit according to the embodiment of the present disclosure.

FIG. 10 is a cross-sectional view schematically illustrating a structure of a pixel array unit according to Modification 1 of the embodiment of the present disclosure.

FIG. 11 is a cross-sectional view schematically illustrating a structure of a pixel array unit according to Modification 2 of the embodiment of the present disclosure.

FIG. 12 is a cross-sectional view schematically illustrating a structure of a pixel array unit according to Modification 3 of the embodiment of the present disclosure.

FIG. 13 is a cross-sectional view schematically illustrating a structure of a pixel array unit according to Modification 4 of the embodiment of the present disclosure.

FIG. 14 is a cross-sectional view schematically illustrating a structure of a pixel array unit according to Modification 5 of the embodiment of the present disclosure.

FIG. 15 is a cross-sectional view schematically illustrating a structure of a pixel array unit according to Modification 6 of the embodiment of the present disclosure.

FIG. 16 is a cross-sectional view schematically illustrating a structure of a pixel array unit according to Modification 7 of the embodiment of the present disclosure.

FIG. 17 is a plan view illustrating an example of a configuration of a color splitter layer according to Modifications 8 and 9 of the embodiment of the present disclosure.

FIG. 18 is a plan view illustrating an example of a configuration of an antireflection film according to Modification 8 of the embodiment of the present disclosure.

FIG. 19 is a plan view illustrating an example of a configuration of an antireflection film according to Modification 9 of the embodiment of the present disclosure.

FIG. 20 is a cross-sectional view schematically illustrating a structure of a pixel array unit according to Modification 10 of the embodiment of the present disclosure.

FIG. 21 is a cross-sectional view schematically illustrating a structure of a pixel array unit according to Modification 11 of the embodiment of the present disclosure.

FIG. 22 is a block diagram illustrating a configuration example of an imaging device as an electronic device to which the technology according to the present disclosure is applied.

Description of Embodiments

Hereinafter, an embodiment of the present disclosure will be described in detail with reference to the drawings. Note that in each of the following embodiments, the same parts are denoted by the same reference numerals, and redundant description will be omitted.

In recent years, electronic devices such as digital cameras are becoming increasingly popular, and demands for photodetection elements such as image sensors, which are main components of the electronic devices, are increasing. Accordingly, technology development for achieving high performance and high functionality of the photodetection element has been actively conducted.

For example, the above-described conventional technology discloses a technology of improving sensitivity of the photodetection element by allowing light of a corresponding color to enter not only from immediately above but also from an adjacent region using a color splitter having a meta-surface structure.

However, in the above-described conventional technology, an antireflection film formed on a surface of the photodetection element is not necessarily optimized, and thus there is room for further improvement in terms of improving sensitivity.

Accordingly, it is expected to achieve a technology capable of overcoming the above-described problems and improving the sensitivity of the photodetection element.

[Configuration of solid-state imaging element]

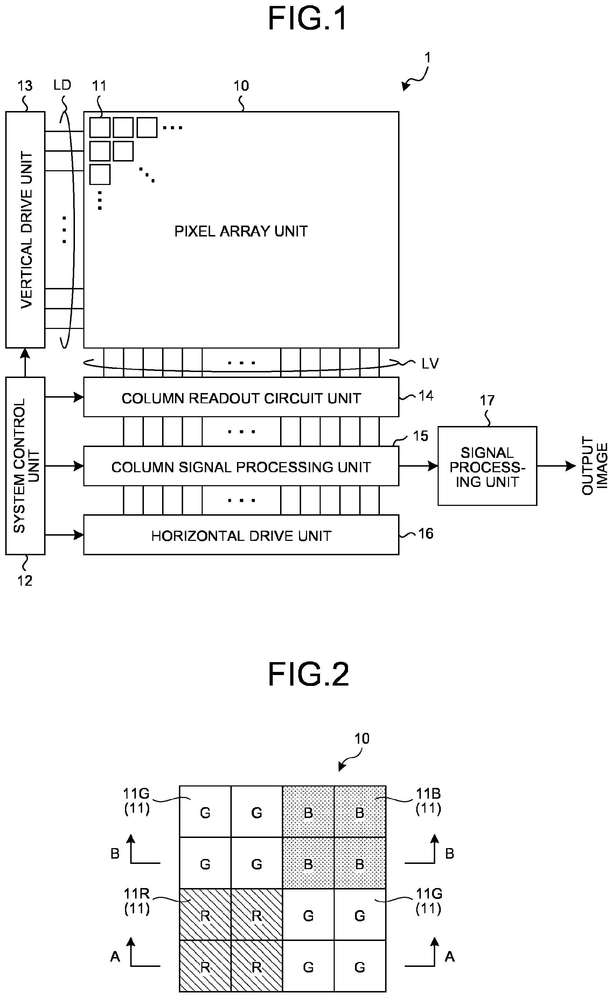

FIG. 1 is a system configuration diagram illustrating a schematic configuration example of a solid-state imaging element 1 according to an embodiment of the present disclosure. The solid-state imaging element 1 is an example of a photodetection element. Note that the photodetection element of the present disclosure is not limited to the solid-state imaging element, and may be various photodetection elements such as a single-photon avalanche diode (SPAD) element and an avalanche photo diode (APD) element.

As illustrated in FIG. 1, the solid-state imaging element 1 that is a CMOS image sensor includes a pixel array unit 10, a system control unit 12, a vertical drive unit 13, a column readout circuit unit 14, a column signal processing unit 15, a horizontal drive unit 16, and a signal processing unit 17.

The pixel array unit 10, the system control unit 12, the vertical drive unit 13, the column readout circuit unit 14, the column signal processing unit 15, the horizontal drive unit 16, and the signal processing unit 17 are provided on the same semiconductor substrate or on a plurality of electrically connected stacked semiconductor substrates.

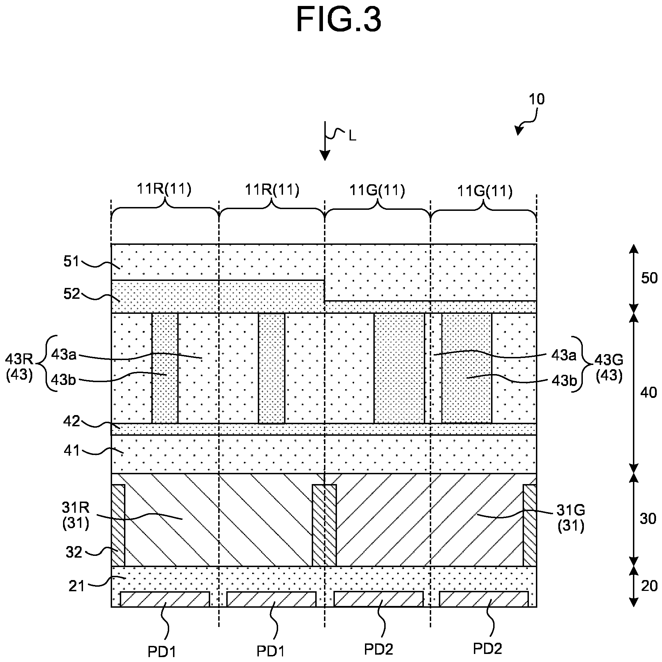

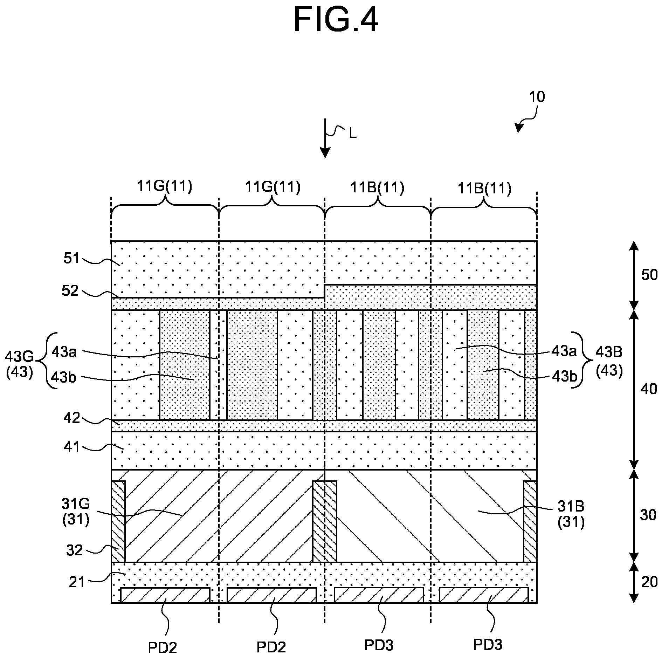

In the pixel array unit 10, effective unit pixels 11 each having photoelectric conversion elements (photodiodes PD1, PD2 (see FIG. 3), and PD3 (see FIG. 4)) capable of photoelectrically converting a charge amount according to an incident light amount, accumulating the charge amount therein, and outputting the charge amount as a signal are two-dimensionally arranged in a matrix. Note that, in the following description, an effective unit pixel 11 is also referred to as a "unit pixel 11".

Further, the pixel array unit 10 may include a region in which dummy unit pixels having a structure without the photodiodes PD1 to PD3, light-shielding unit pixels in which light incidence from the outside is blocked by shielding a light-receiving surface, and the like are arranged in a row and/or column shape, in addition to the effective unit pixels 11.

Note that the light-shielding unit pixel may have a configuration similar to that of the effective unit pixel 11 except for having a structure in which the light-receiving surface is shielded from light. Further, in the following description, a photocharge of a charge amount according to the amount of incident light may also simply referred to as "charge", and the unit pixel 11 may also simply referred to as a "pixel".

In the pixel array unit 10, a pixel drive line LD is formed for each row along a left-right direction in the drawing (an array direction of the pixels in the pixel row) with respect to the pixel array in a matrix, and a vertical pixel wiring LV is formed for each column along an up-down direction in the drawing (an array direction of the pixels in the pixel column). One end of the pixel drive line LD is connected to an output terminal corresponding to each row of the vertical drive unit 13.

The column readout circuit unit 14 includes at least a circuit that supplies a constant current to the unit pixel 11 in a selected row in the pixel array unit 10 for each column, a current mirror circuit, a changeover switch of the unit pixel 11 to be read, and the like.

Then, the column readout circuit unit 14 configures an amplifier together with a transistor in a selected pixel in the pixel array unit 10, converts a photocharge signal into a voltage signal, and outputs the voltage signal to the vertical pixel wiring LV.

The vertical drive unit 13 includes a shift register, an address decoder, and the like, and drives each unit pixel 11 of the pixel array unit 10 at the same time for all pixels or in units of rows. Although a specific configuration of the vertical drive unit 13 is not illustrated, the vertical drive unit has a configuration including a readout scanning system and a sweep scanning system or a batch sweeping and batch transfer system.

In order to read pixel signals from the unit pixels 11, the readout scanning system sequentially selects and scans the unit pixels 11 of the pixel array unit 10 row by row. In the case of row driving (rolling shutter operation), sweep scanning is performed on a read row on which readout scanning is performed by the readout scanning system prior to the readout scanning by a time corresponding to a shutter speed.

Further, in the case of global exposure (global shutter operation), batch sweeping is performed prior to batch transfer by the time corresponding to the shutter speed. By such sweeping, unnecessary charges are swept (reset) from the photodiodes PD1 to PD3 and the like of the unit pixel 11 in the read row. Then, what is called electronic shutter operation is performed by sweeping (resetting) unnecessary charges.

Here, the electronic shutter operation refers to an operation of discarding unnecessary photocharges accumulated in the photodiodes PD1 to PD3 and the like immediately before and newly starting exposure (starting accumulation of photocharges).

A signal read by read operation by the readout scanning system corresponds to the amount of light incident after the immediately preceding read operation or electronic shutter operation. In the case of row driving, a period from a read timing by the immediately preceding read operation or a sweep timing by the electronic shutter operation to a read timing by the current read operation is the photocharge accumulation time (exposure time) in the unit pixel 11. In the case of global exposure, the time from batch sweeping to batch transfer is the accumulation time (exposure time).

The pixel signal output from each unit pixel 11 of the pixel row selectively scanned by the vertical drive unit 13 is supplied to the column signal processing unit 15 through each of the vertical pixel wirings LV. The column signal processing unit 15 performs predetermined signal processing on the pixel signal output from each unit pixel 11 of the selected row through the vertical pixel wiring LV for each pixel column of the pixel array unit 10, and temporarily holds the pixel signal after the signal processing.

Specifically, the column signal processing unit 15 performs at least noise removal processing, for example, correlated double sampling (CDS) processing as signal processing. By the CDS processing by the column signal processing unit 15, fixed pattern noise unique to pixels such as reset noise and threshold variation of an amplification transistor AMP is removed.

Note that the column signal processing unit 15 can have, for example, an AD conversion function in addition to the noise removal processing, and can be configured to output the pixel signal as a digital signal.

The horizontal drive unit 16 includes a shift register, an address decoder, and the like, and sequentially selects a unit circuit corresponding to a pixel column of the column signal processing unit 15. By selective scanning by the horizontal drive unit 16, pixel signals subjected to the signal processing by the column signal processing unit 15 are sequentially output to the signal processing unit 17.

The system control unit 12 includes a timing generator that generates various timing signals, and the like, and performs drive control of the vertical drive unit 13, the column signal processing unit 15, the horizontal drive unit 16, and the like on the basis of various timing signals generated by the timing generator.

The solid-state imaging element 1 further includes a signal processing unit 17 and a data storage unit (not illustrated). The signal processing unit 17 has at least an addition processing function, and performs various types of signal processing such as addition processing on the pixel signal output from the column signal processing unit 15.

The data storage unit temporarily stores data necessary for signal processing in the signal processing unit 17. The signal processing unit 17 and the data storage unit may be processing by an external signal processing unit provided on a substrate different from the solid-state imaging element 1, for example, a digital signal processor (DSP) or software, or may be mounted on the same substrate as the solid-state imaging element 1.

[Configuration of Pixel Array Unit]

Next, a detailed configuration of the pixel array unit 10 will be described with reference to FIGS. 2 to 9. FIG. 2 is a plan view illustrating an example of a configuration of the pixel array unit 10 according to the embodiment of the present disclosure. As illustrated in FIG. 2, the pixel configuration of the pixel array unit 10 according to the embodiment is based on a pixel block in which 2 pixels ×2 pixels of the same color are arranged in a lattice pattern.

Then, the pixel array unit 10 is configured so that each pixel block including four pixels 11R that receive red light, four pixels 11G that receive green light, and four pixels 11B that receive blue light is arranged in a pixel array according to the Bayer array. Hereinafter, such a pixel array is referred to as a four-divided Bayer RGB array.

Specifically, in the pixel array unit 10, pixel blocks including the pixel 11R, the pixel 11G, and the pixel 11B are arranged in a 2 × 2 lattice pattern so that the numbers of the pixels 11R, the pixels 11G, and the pixels 11B are at a ratio of 1 : 2 : 1, and the pixel blocks of the same color are not adjacent.

In the example of FIG. 2, the pixel block including the pixel 11G is arranged on the left and under the pixel block of the pixel 11B, and the pixel block including the pixel 11R is arranged diagonally to the pixel block of the pixel 11B.

FIG. 3 is a cross-sectional view taken along line A-A illustrated in FIG. 2, and is a cross-sectional view schematically illustrating a structure of a portion where the pixels 11R and the pixels 11G are arranged in the pixel array unit 10. Further, FIG. 4 is a cross-sectional view taken along line B-B illustrated in FIG. 2, and is a cross-sectional view schematically illustrating a structure of a portion where the pixels 11G and the pixels 11B are arranged in the pixel array unit 10.

As illustrated in FIGS. 3 and 4, the pixel array unit 10 includes a semiconductor layer 20, a color filter layer 30, a spectral layer 40, and antireflection films 50. Then, in the pixel array unit 10, the antireflection films 50, the spectral layer 40, the color filter layer 30, and the semiconductor layer 20 are stacked in this order from the side (hereinafter also referred to as a light incident side) on which the incident light L from the outside is incident.

The semiconductor layer 20 includes a semiconductor region (not illustrated) of a first conductivity type (for example, P-type) and a plurality of semiconductor regions (not illustrated) of a second conductivity type (for example, N-type). Then, in the semiconductor region of the first conductivity type, a plurality of semiconductor regions of the second conductivity type is formed side by side in a planar direction (arrangement direction of the pixels 11) in units of pixels, whereby the photodiodes PD1 to PD3 by PN junction are formed side by side.

The photodiode PD1 is an example of a first photoelectric conversion unit and is provided in the pixel 11R. The photodiode PD2 is an example of a second photoelectric conversion unit and is provided in the pixel 11G. The photodiode PD3 is an example of a third photoelectric conversion unit. It is provided in the pixel 11B.

Further, the red light received and photoelectrically converted by the photodiode PD1 is an example of light in a first wavelength range, and the green light received and photoelectrically converted by the photodiode PD2 is an example of light in a second wavelength range. Furthermore, the blue light received and photoelectrically converted by the photodiode PD3 is an example of light in a third wavelength range.

An insulating film 21 is arranged on a surface of the semiconductor layer 20 on a light incident side. Such an insulating film 21 includes, for example, a fixed charge film.

Note that a wiring layer, not illustrated, is arranged on a surface of the semiconductor layer 20 opposite to the light incident side. Such a wiring layer is configured by forming a plurality of wiring films (not illustrated) and a plurality of pixel transistors (not illustrated) in an interlayer insulating film (not illustrated). The plurality of such pixel transistors performs reading of electric charges accumulated in the photodiodes PD1 to PD3, and the like.

The color filter layer 30 is arranged on a surface of the semiconductor layer 20 on the light incident side. The color filter layer 30 includes a color filter 31 and a light shielding wall 32.

The color filter 31 is an optical filter that transmits light in a predetermined wavelength range among the incident light L. The color filter 31 includes, for example, a color filter 31R that transmits red light, a color filter 31G that transmits green light, and a color filter 31B that transmits blue light.

The color filter 31R is arranged on the light incident side of the photodiode PD1. The color filter 31G is arranged on the light incident side of the photodiode PD2. The color filter 31B is arranged on the light incident side of the photodiode PD3. For example, the color filter 31 is individually formed for each pixel block in which the unit pixels 11 are arranged in a 2 × 2 lattice pattern in the pixel array unit 10.

The light shielding wall 32 is a wall-shaped film that shields light obliquely incident from an adjacent pixel block. The light shielding wall 32 is provided inside the color filter layer 30 so as to surround the pixel block in plan view. The light shielding wall 32 includes, for example, aluminum, tungsten, or the like.

The spectral layer 40 is arranged on a surface of the color filter layer 30 on the light incident side. Such a spectral layer 40 includes an intermediate layer 41, a stopper film 42, and a color splitter layer 43. Then, in the spectral layer 40, the color splitter layer 43, the stopper film 42, and the intermediate layer 41 are stacked in this order from the light incident side.

The intermediate layer 41 is a layer for adjusting the focal length between the color splitter layer 43 and the photodiodes PD1 to PD3. As will be described later, such an intermediate layer 41 is provided to ensure a distance necessary for allowing red light, green light, and blue light dispersed in different directions in the color splitter layer 43 to enter desired photodiodes PD1 to PD3.

The intermediate layer 41 includes, for example, a material having a low refractive index. The intermediate layer 41 includes, for example, a metal oxide such as silicon oxide or aluminum oxide, or an organic substance such as an acrylic resin.

The stopper film 42 functions as an etching stopper when a recess corresponding to a columnar high refractive index portion 43b is formed inside a low refractive index layer 43a in the formation process of the color splitter layer 43.

The stopper film 42 includes, for example, a silicon compound such as silicon nitride or silicon carbide, a metal oxide such as titanium oxide, tantalum oxide, niobium oxide, hafnium oxide, indium oxide, or tin oxide, or a composite oxide thereof. That is, the stopper film 42 includes a material having a refractive index higher than that of the intermediate layer 41.

The color splitter layer 43 includes the low refractive index layer 43a and a plurality of high refractive index portions 43b. The low refractive index layer 43a includes a material having a refractive index lower than that of the high refractive index portion 43b. The low refractive index layer 43a includes, for example, a metal oxide such as silicon oxide or aluminum oxide, or an organic substance such as an acrylic resin.

The high refractive index portion 43b having a predetermined shape (for example, a column shape) is provided inside the low refractive index layer 43a. The high refractive index portion 43b includes a material having a refractive index higher than that of the low refractive index layer 43a.

The high refractive index portion 43b includes, for example, a silicon compound such as silicon nitride or silicon carbide, a metal oxide such as titanium oxide, tantalum oxide, niobium oxide, hafnium oxide, indium oxide, or tin oxide, or a composite oxide thereof. In addition, the high refractive index portion 43b may be made by an organic substance such as siloxane.

In the color splitter layer 43, a plurality of color splitters 43R, 43G, and 43B including the high refractive index portion 43b and the low refractive index layer 43a adjacent to such a high refractive index portion 43b is arranged.

The color splitter 43R is arranged on the light incident side of a pixel block in which the pixels 11R are arranged in a 2 × 2 lattice pattern. The color splitter 43G is arranged on the light incident side of a pixel block in which the pixels 11G are arranged in a 2 × 2 lattice pattern. The color splitter 43B is arranged on the light incident side of a pixel block in which the pixels 11B are arranged in a 2 × 2 lattice pattern.

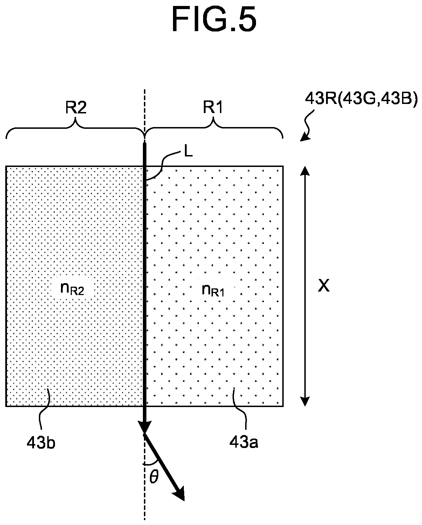

Here, the principle of the color splitters 43R, 43G, and 43B according to the embodiment will be described with reference to FIG. 5. FIG. 5 is a view for describing the principle of the color splitters 43R, 43G, and 43B according to the embodiment of the present disclosure.

As illustrated in FIG. 5, in the color splitter 43R (or the color splitters 43G, 43B), a first region R1 where the low refractive index layer 43a is located and a second region R2 where the high refractive index portion 43b is located are arranged.

Specifically, in the first region R1, the low refractive index layer 43a having a low refractive index (for example, a refractive index $n_{R1}$) is arranged along the light incident direction by a length X. Further, in the second region R2, the high refractive index portion 43b having a high refractive index (for example, a refractive index $n_{R2}$) is arranged along the light incident direction by the length X.

In the color splitter 43R or the like having such a configuration, when the incident light L is simultaneously incident on the first region R1 and the second region R2, a difference in the traveling distance of the incident light L occurs between the first region R1 and the second region R2 due to a refractive index difference between the low refractive index layer 43a and the high refractive index portion 43b.

Specifically, an optical path length D1 of the first region R1 is obtained by the following Expression (1).

$$D1 = n_{R1} \times X \qquad (1)$$

Further, an optical path length D2 of the second region R2 is obtained by the following Expression (2).

$$D2 = n_{R2} \times X \qquad\qquad (2)$$

On the basis of such Expressions (1) and (2), an optical path length difference $\Delta D$ between the first region R1 and the second region R2 is obtained by the following Expression (3).

$$\Delta D = D2 - D1 = X \times (n_{R2} - n_{R1}) \qquad\qquad (3)$$

Then, the incident light L having passed through the color splitters 43R, 43G, and 43B is bent and emitted toward the first region R1 where the light travels with a delay as illustrated in FIG. 5 by the optical path length difference $\Delta D$ between the first region R1 and the second region R2.

A bending angle $\theta$ of such incident light L is obtained by the following Expression (4).

$$\theta = \arctan(\Delta D/\lambda) = \arctan(X \times (n_{R2} - n_{R1})/\lambda) \qquad (4)$$

$\lambda$: wavelength of incident light L

As illustrated in the above Expression (4), the bending angle $\theta$ of the incident light L depends on the wavelength $\lambda$ of the incident light L. Thus, by appropriately selecting the refractive indexes $n_{R1}$, and $n_{R2}$ of the low refractive index layer 43a and the high refractive index portion 43b in accordance with respective wavelength ranges, the color splitters 43R, 43G, and 43B can bend the light in the respective wavelength ranges in different desired directions.

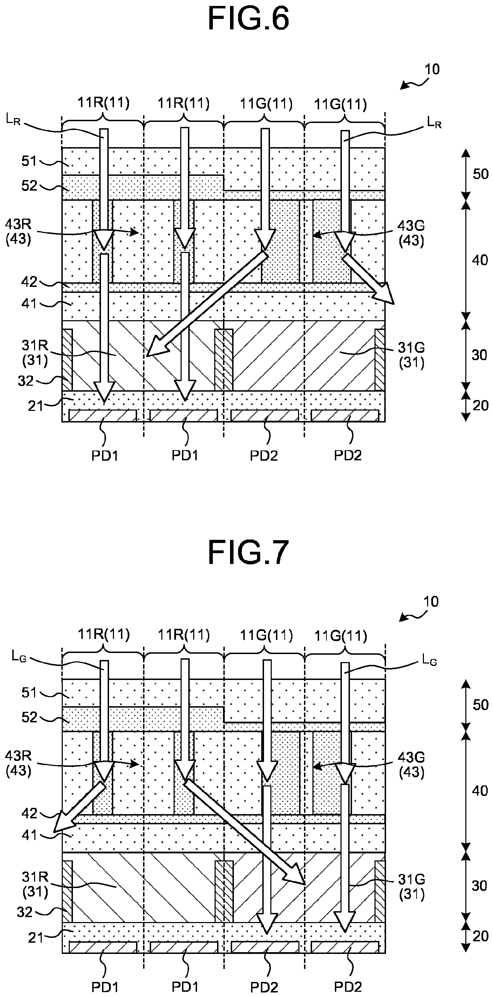

FIG. 6 is a view illustrating an incident state of the incident light L in the pixel array unit 10 according to the embodiment of the present disclosure, and is a view illustrating an incident state of red light $L_R$ among the incident light L in a cross-sectional configuration illustrated in FIG. 3.

As illustrated in FIG. 6, among the incident light L, the red light $L_R$ is hardly bent in the color splitter 43R, and is directly incident on the photodiode PD1 located on the light incident side of such a color splitter 43R. On the other hand, the red light $L_R$ is largely bent at the color splitter 43G and is incident on the photodiode PD1 adjacent to the photodiode PD2 below such a color splitter 43G.

FIG. 7 is a view illustrating an incident state of the incident light L in the pixel array unit 10 according to the embodiment of the present disclosure, and is a view illustrating an incident state of green light $L_G$ among the incident light L in the cross-sectional configuration illustrated in FIG. 3.

As illustrated in FIG. 7, among the incident light L, the green light $L_G$ is hardly bent by the color splitter 43G and is directly incident on the photodiode PD2 located below such a color splitter 43G. On the other hand, the green light $L_G$ is largely bent in the color splitter 43R and is incident on the photodiode PD2 adjacent to the photodiode PD1 below such a color splitter 43R.

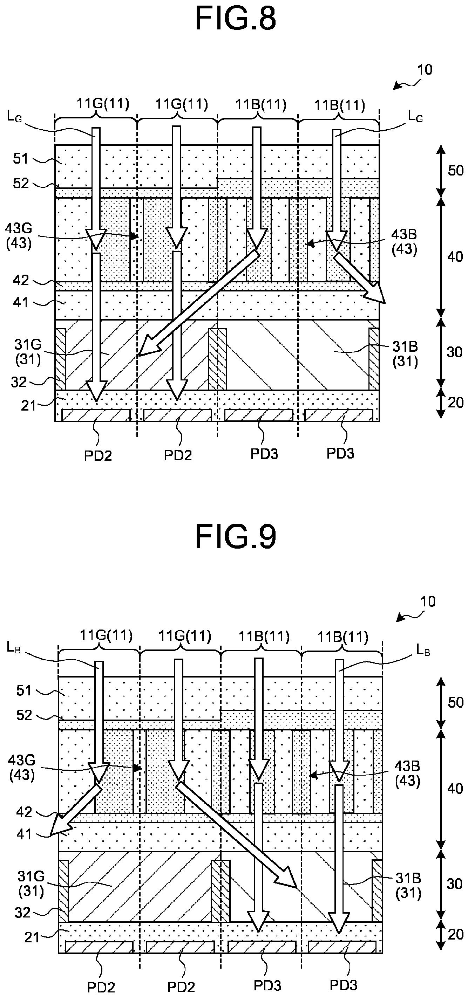

FIG. 8 is a view illustrating an incident state of the incident light L in the pixel array unit 10 according to the embodiment of the present disclosure, and is a view illustrating an incident state of the green light $L_G$ among the incident light L in a cross-sectional configuration illustrated in FIG. 4.

As illustrated in FIG. 8, among the incident light L, the green light $L_G$ is hardly bent by the color splitter 43G and is directly incident on the photodiode PD2 located below such a color splitter 43G. On the other hand, the green light $L_G$ is largely bent in the color splitter 43B and is incident on the photodiode PD2 adjacent to the photodiode PD3 below such a color splitter 43B.

FIG. 9 is a view illustrating an incident state of the incident light L in the pixel array unit 10 according to the embodiment of the present disclosure, and is a view illustrating an incident state of blue light $L_B$ among the incident light L in the cross-sectional configuration illustrated in FIG. 4.

As illustrated in FIG. 9, among the incident light L, the blue light $L_B$ is hardly bent in the color splitter 43B, and is directly incident on the photodiode PD3 located below such a color splitter 43B. On the other hand, the blue light $L_B$ is largely bent at the color splitter 43G and is incident on the photodiode PD3 adjacent to the photodiode PD2 below such a color splitter 43G.

As described above, in the embodiment, by arranging the color splitters 43R, 43G, and 43B having a meta-surface structure on the light incident side of the photodiodes PD1 to PD3, light of a corresponding color can be incident not only from immediately above but also from an adjacent region. Therefore, according to the embodiment, sensitivity of the solid-state imaging element 1 can be improved.

Note that the "meta-surface structure" refers to a structure in which a plurality of columnar portions (high refractive index portions 43b) formed in one color splitter 43R, 43G, or 43B is arranged at a period equal to or less than the wavelength $\lambda$ of the incident light L.

With such a structure, the effective refractive indexes of the color splitters 43R, 43G, and 43B can be changed, and thus the light $L_R$, $L_G$, and $L_B$ having different wavelength ranges can be further bent in desired directions.

Furthermore, in the embodiment, by arranging the color filter 31 between the photodiodes PD1 to PD3 and the color splitters 43R, 43G, and 43B, even in a case where light different from the corresponding color is incident, such light can be suppressed from being photoelectrically converted. Therefore, according to the embodiment, color mixing of the solid-state imaging element 1 can be suppressed.

The description returns to FIGS. 3 and 4. An antireflection film 50 is arranged on a surface of the spectral layer 40 on the light incident side. Such an antireflection film 50 suppresses reflection of the incident light L on the surface of the pixel array unit 10. With this configuration, the amount of light incident on the inside of the pixel array unit 10 can be increased, and thus the sensitivity of the solid-state imaging element 1 can be improved.

The antireflection film 50 includes, for example, a first layer 51 and a second layer 52. Then, in the antireflection film 50, the first layer 51 and the second layer 52 are stacked in this order from the light incident side.

The first layer 51 includes, for example, a material having a refractive index n1 lower than that of the second layer 52. The first layer 51 includes, for example, a metal oxide such as silicon oxide or aluminum oxide, or an organic substance such as an acrylic resin.

The second layer 52 includes, for example, a material having a refractive index n2 higher than that of the first layer 51. The second layer 52 includes, for example, a silicon compound such as silicon nitride or silicon carbide, a metal oxide such as titanium oxide, tantalum oxide, niobium oxide, hafnium oxide, indium oxide, or tin oxide, or a composite oxide thereof. In addition, the second layer 52 may be made by an organic substance such as siloxane.

Here, in the embodiment, as illustrated in FIGS. 3 and 4, the antireflection films 50 located on the light incident side of the photodiodes PD1, PD2, and PD3 have configurations different from each other. With this configuration, reflection of the incident light L on the surface of the pixel array unit 10 can be further suppressed. The reason will be described below.

As described above, the color splitters 43R, 43G, and 43B bend light of different wavelength ranges in different directions, and thus the sizes of the high refractive index portions 43b therein are different. Thus, the color splitters 43R, 43G, and 43B have different average refractive indexes (effective refractive indexes).

Thus, in a case where a uniform antireflection film 50 is arranged on the light incident side of the color splitters 43R, 43G, and 43B, while an antireflection effect of a certain region is sufficient, an antireflection effect of another region may not be sufficiently obtained.

Accordingly, in the embodiment, by arranging the antireflection films 50 having configurations optimized according to the effective refractive indexes of the color splitters 43R, 43G, and 43B, a sufficient antireflection effect can be obtained in all the regions.

As described above, in the embodiment, by arranging the antireflection films 50 having different configurations on the light incident side of the color splitters 43R, 43G, and 43B, the amount of light incident on the inside of the pixel array unit 10 can be increased. Therefore, according to the embodiment, the sensitivity of the solid-state imaging element 1 can be improved.

Furthermore, in the embodiment, reflection on the surface of the pixel array unit 10 can be reduced, and thus it is possible to suppress flare and ghost caused by internal turbulence reflection in the solid-state imaging element 1.

In addition, in the embodiment, as illustrated in FIGS. 3 and 4, the antireflection films 50 arranged on the light incident side of the photodiodes PD1, PD2, and PD3 may have different film thicknesses of the first layer 51 and the second layer 52 from each other.

With this configuration, the antireflection films 50 optimized according to the respective effective refractive indexes of the color splitters 43R, 43G, and 43B can be easily configured. Therefore, according to the embodiment, the sensitivity of the solid-state imaging element 1 can be easily improved.

In addition, in the embodiment, the total film thicknesses of the first layer 51 and the second layer 52 of the antireflection films 50 arranged on the light incident side of the photodiodes PD1, PD2, and PD3 may be the same. With this configuration, the surface of the pixel array unit 10 can be made flat.

[Various modifications]

<Modification 1>

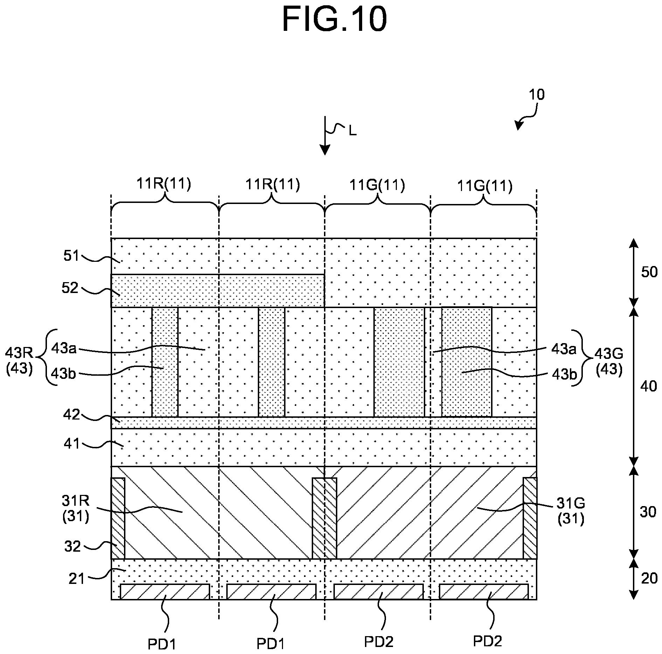

Next, various modifications of the pixel array unit 10 according to the embodiment of the present disclosure will be described with reference to FIGS. 10 to 21.

FIG. 10 is a cross-sectional view schematically illustrating a structure of a pixel array unit 10 according to Modification 1 of the embodiment of the present disclosure, and is a view corresponding to FIG. 3 of the embodiment. Note that, in the following various modifications, only cross-sectional views (corresponding to FIG. 3) of the pixel 11R and the pixel 11G are illustrated, and cross-sectional views (corresponding to FIG. 4) of the pixel 11G and the pixel 11B are not illustrated.

In the pixel array unit 10 according to Modification 1, the configuration of the antireflection films 50 is different from that of the above-described embodiment. Specifically, in Modification 1, at least one of the antireflection films 50 arranged on the light incident side of the photodiodes PD1, PD2, and PD3 does not include the first layer 51 or the second layer 52.

For example, as illustrated in FIG. 10, the antireflection films 50 arranged on the light incident side of the photodiode PD2 does not include the second layer 52, and includes only the first layer 51.

Also with this configuration, the antireflection films 50 optimized according to the effective refractive indexes of the color splitters 43R, 43G, and 43B can be configured. Therefore, according to Modification 1, the amount of light incident on the inside of the pixel array unit 10 can be increased, and thus the sensitivity of the solid-state imaging element 1 can be improved.

Note that, in the example of FIG. 10, a case where at least one of the antireflection films 50 arranged on the light incident side of the photodiodes PD1, PD2, and PD3 does not include the second layer 52 has been described, but the present disclosure is not limited to such an example.

For example, at least one of the antireflection films 50 arranged on the light incident side of the photodiodes PD1, PD2, and PD3 may not include the first layer 51 and may include only the second layer 52.

<Modification 2>

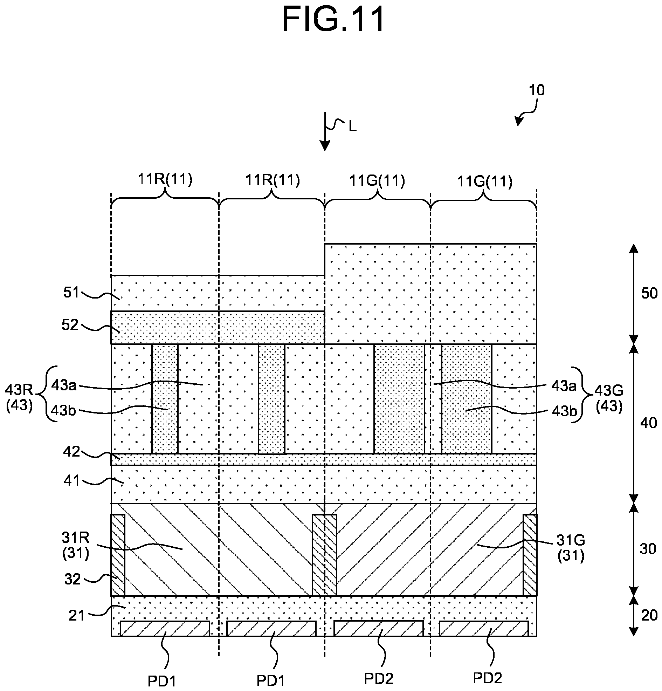

FIG. 11 is a cross-sectional view schematically illustrating a structure of a pixel array unit 10 according to Modification 2 of the embodiment of the present disclosure. In the pixel array unit 10 according to Modification 2, the configuration of the antireflection films 50 is different from that of Modification 1 described above.

Specifically, in Modification 2, at least one of the antireflection films 50 arranged on the light incident side of the photodiodes PD1, PD2, and PD3 is different from another antireflection film 50 in total film thickness of the first layer 51 and the second layer 52.

For example, as illustrated in FIG. 11, the total film thickness of the first layer 51 and the second layer 52 (only the first layer 51 in the drawing) of the antireflection film 50 arranged on the light incident side of the photodiode PD2 is larger than that of the antireflection film 50 arranged on the light incident side of the photodiode PD1.

With this configuration, the antireflection films 50 further optimized according to the effective refractive indexes of the color splitters 43R, 43G, and 43B can be configured. Therefore, according to Modification 2, the amount of light incident on the inside of the pixel array unit 10 can be further increased, and thus the sensitivity of the solid-state imaging element 1 can be further improved.

<Modification 3>

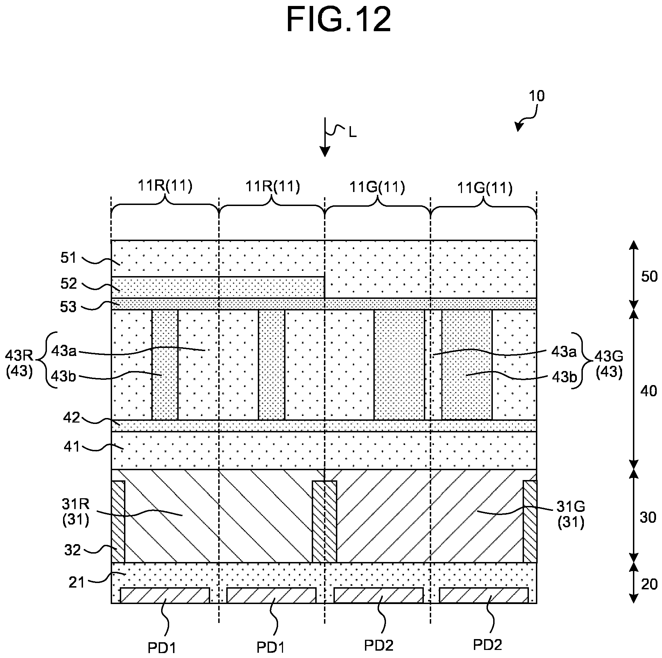

FIG. 12 is a cross-sectional view schematically illustrating a structure of a pixel array unit 10 according to Modification 3 of the embodiment of the present disclosure. In the pixel array unit 10 according to Modification 3, the configuration of the antireflection films 50 is different from that of the above-described embodiment.

Specifically, in Modification 3, the antireflection film 50 includes a third layer 53 in addition to the first layer 51 and the second layer 52. Then, in the antireflection film 50, the first layer 51, the second layer 52, and the third layer 53 are stacked in this order from the light incident side.

The third layer 53 includes, for example, a material having a refractive index n3 higher than that of the first layer 51. Note that both the refractive index n3 of the third layer 53 and the refractive index n2 of the second layer 52 may be high.

The third layer 53 includes, for example, a silicon compound such as silicon nitride or silicon carbide, a metal oxide such as titanium oxide, tantalum oxide, niobium oxide, hafnium oxide, indium oxide, or tin oxide, or a composite oxide thereof. In addition, the third layer 53 may be made by an organic substance such as siloxane.

With this configuration, the antireflection films 50 further optimized according to the effective refractive indexes of the color splitters 43R, 43G, and 43B can be configured. Therefore, according to Modification 3, the amount of light incident on the inside of the pixel array unit 10 can be further increased, and thus the sensitivity of the solid-state imaging element 1 can be further improved.

In addition, in Modification 3, at least one of the antireflection films 50 arranged on the light incident side of the photodiodes PD1, PD2, and PD3 may not have at least one of the first layer 51, the second layer 52, or the third layer 53.

For example, as illustrated in FIG. 12, the antireflection film 50 arranged on the light incident side of the photodiode PD2 does not include the second layer 52, and includes only the first layer 51 and the third layer 53.

Also with this configuration, the antireflection films 50 optimized according to the effective refractive indexes of the color splitters 43R, 43G, and 43B can be configured. Therefore, according to Modification 3, the amount of light incident on the inside of the pixel array unit 10 can be increased, and thus the sensitivity of the solid-state imaging element 1 can be improved.

Note that, in the example of FIG. 12, a case where at least one of the antireflection films 50 arranged on the light incident side of the photodiodes PD1, PD2, and PD3 does not include the second layer 52 has been described, but the present disclosure is not limited to such an example.

For example, at least one of the antireflection films 50 arranged on the light incident side of the photodiodes PD1, PD2, and PD3 may not include the first layer 51, and may include only the second layer 52 and the third layer 53. In addition, at least one of the antireflection films 50 arranged on the light incident side of the photodiodes PD1, PD2, and PD3 may not include the third layer 53 and may include only the first layer 51 and the second layer 52.

<Modification 4>

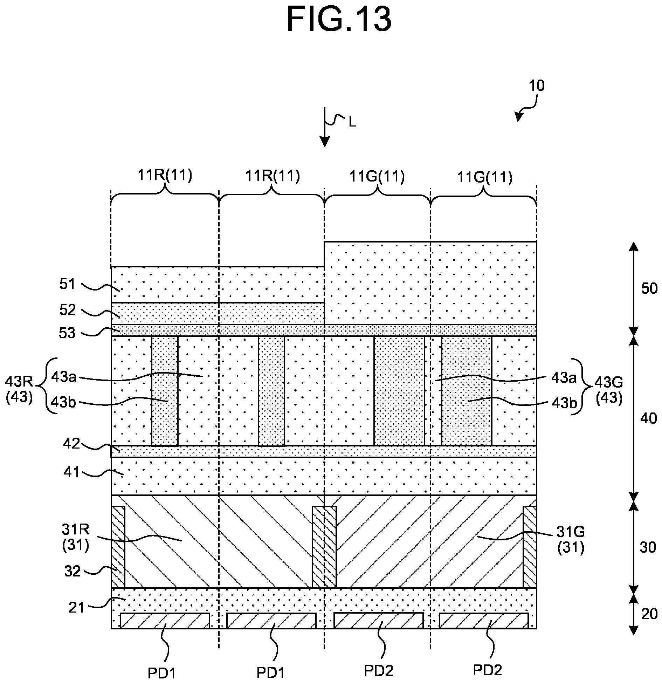

FIG. 13 is a cross-sectional view schematically illustrating a structure of a pixel array unit 10 according to Modification 4 of the embodiment of the present disclosure. In the pixel array unit 10 according to Modification 4, the configuration of the antireflection films 50 is different from that of Modification 3 described above.

Specifically, in Modification 4, at least one of the antireflection films 50 arranged on the light incident side of the photodiodes PD1, PD2, and PD3 is different from another antireflection film 50 in total film thickness of the first layer 51, the second layer 52, and the third layer 53.

For example, as illustrated in FIG. 13, in the antireflection film 50 arranged on the light incident side of the photodiode PD2, the total film thickness of the first layer 51 to the third layer 53 (the first layer 51 and the third layer 53 in the drawing) is larger than that of the antireflection film 50 arranged on the light incident side of the photodiode PD1.

With this configuration, the antireflection films 50 further optimized according to the effective refractive indexes of the color splitters 43R, 43G, and 43B can be configured. Therefore, according to Modification 4, the amount of light incident on the inside of the pixel array unit 10 can be further increased, and thus the sensitivity of the solid-state imaging element 1 can be further improved.

<Modification 5>

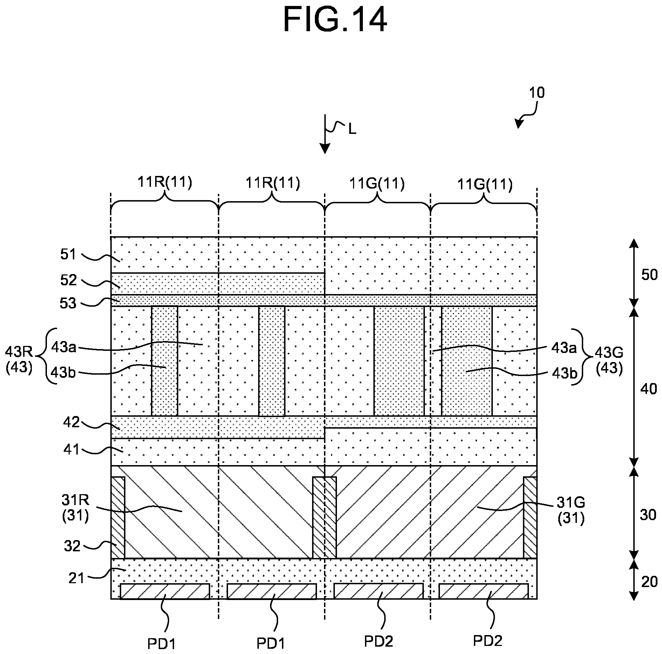

FIG. 14 is a cross-sectional view schematically illustrating a structure of a pixel array unit 10 according to Modification 5 of the embodiment of the present disclosure. In the pixel array unit 10 according to Modification 5, the configuration of the stopper films 42 is different from that of Modification 3 described above.

Specifically, in Modification 5, as illustrated in FIG. 14, the stopper films 42 located on the light incident side of the photodiodes PD1, PD2, and PD3 have configurations different from each other. With this configuration, reflection of the incident light L inside the pixel array unit 10 can be suppressed. The reason will be described below.

The stopper film 42 and the color splitter layer 43 have different refractive indexes, and thus a phenomenon occurs in which the incident light L is reflected at the interface between the stopper film 42 and the color splitter layer 43. Further, as described above, the color splitters 43R, 43G, and 43B have different average refractive indexes (effective refractive indexes).

Thus, in a case where a uniform stopper film 42 is arranged on lower surfaces of the color splitters 43R, 43G, and 43B, there is a possibility that the light reflection generated at the interface between the color splitters 43R, 43G, and 43B and the stopper film 42 decreases in one region but does not decrease in another region.

Accordingly, in Modification 5, by arranging the stopper film 42 having a configuration optimized according to the effective refractive indexes of the color splitters 43R, 43G, and 43B, a sufficient antireflection effect can be obtained in all the regions.

As described above, in Modification 5, by arranging the stopper films 42 having different configurations on the lower surfaces of the color splitters 43R, 43G, and 43B, the amount of light incident on the photodiodes PD1 to PD3 can be increased. Therefore, according to Modification 5, the sensitivity of the solid-state imaging element 1 can be further improved.

In addition, in Modification 5, the film thicknesses of the stopper films 42 arranged on the light incident side of the photodiodes PD1, PD2, and PD3 may be different from each other. With this configuration, the stopper films 42 optimized according to the effective refractive indexes of the color splitters 43R, 43G, and 43B can be easily configured.

Therefore, according to Modification 5, the sensitivity of the solid-state imaging element 1 can be easily improved.

<Modifications 6 and 7>

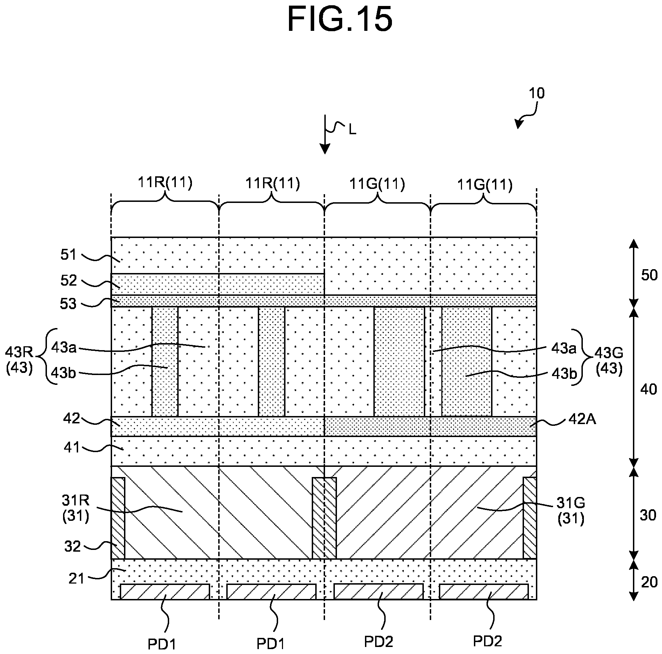

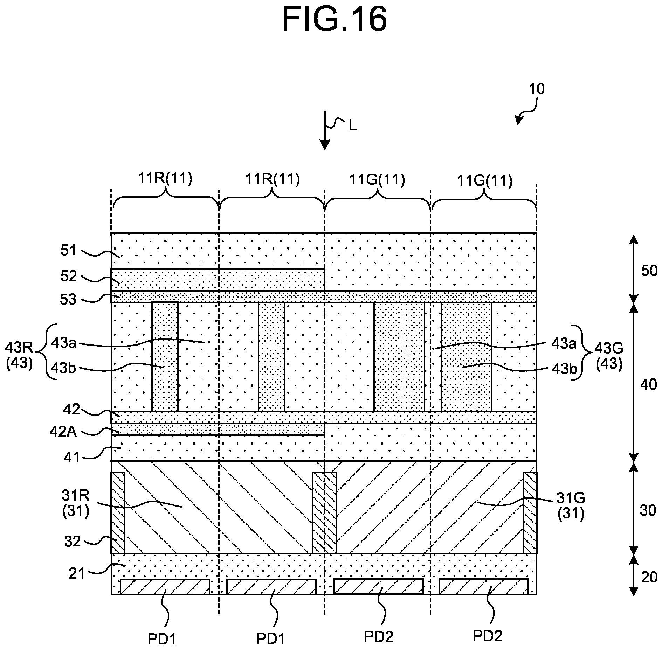

FIGS. 15 and 16 are cross-sectional views schematically illustrating a structure of the pixel array unit 10 according to Modifications 6 and 7 of the embodiment of the present disclosure. In the pixel array unit 10 according to Modifications 6 and 7, the configuration of the stopper films 42 is different from that of Modification 5 described above.

Specifically, in Modification 6, the stopper films 42 located on the light incident side of the photodiodes PD1, PD2, and PD3 are formed by films having different compositions. For example, as illustrated in FIG. 15, the stopper film 42 located on the light incident side of the photodiode PD1 and a stopper film 42A located on the light incident side of the photodiode PD2 are formed by films having different compositions.

Also with this configuration, the amount of light incident on the photodiodes PD1 to PD3 can be increased, so that the sensitivity of the solid-state imaging element 1 can be further improved.

In addition, as illustrated in FIG. 16, in at least one of the stopper films 42 arranged on the light incident side of the photodiodes PD1, PD2, and PD3, the stopper film 42 and the stopper film 42A having different compositions may be stacked.

Also with this configuration, the amount of light incident on the photodiodes PD1 to PD3 can be increased, so that the sensitivity of the solid-state imaging element 1 can be further improved.

<Modifications 8 and 9>

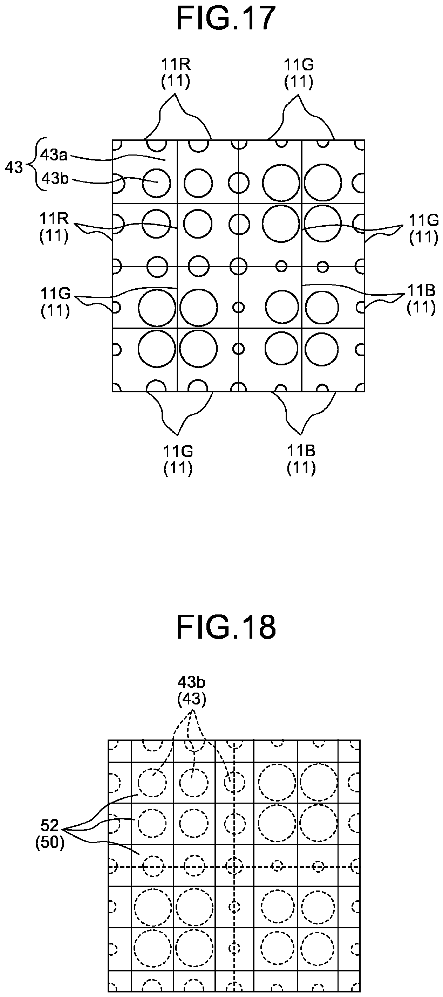

FIG. 17 is a plan view illustrating an example of a configuration of a color splitter layer 43 according to Modifications 8 and 9 of the embodiment of the present disclosure. As illustrated in FIG. 17, in Modifications 8 and 9, the color splitter layer 43 includes a plurality of high refractive index portions 43b having a columnar shape (for example, a cylindrical shape). Furthermore, in Modifications 8 and 9, the plurality of high refractive index portions 43b is arranged side by side at equal intervals in plan view.

FIG. 18 is a plan view illustrating an example of a configuration of the antireflection films 50 according to Modification 8 of the embodiment of the present disclosure. As illustrated in FIG. 18, in Modification 8, the second layer 52 of the antireflection film 50 has a portion whose film thickness is adjusted for each pitch of the plurality of high refractive index portions 43b.

For example, in Modification 8, the second layer 52 whose film thickness is adjusted is arranged for each rectangular region covering one high refractive index portion 43b.

With this configuration, the antireflection films 50 further optimized according to the effective refractive indexes of the color splitters 43R, 43G, and 43B can be configured. Therefore, according to Modification 8, the amount of light incident on the inside of the pixel array unit 10 can be further increased, and thus the sensitivity of the solid-state imaging element 1 can be further improved.

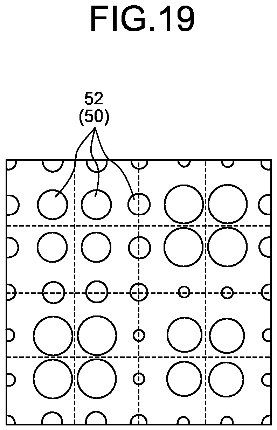

FIG. 19 is a plan view illustrating an example of a configuration of the antireflection films 50 according to Modification 9 of the embodiment of the present disclosure. As illustrated in FIG. 19, in Modification 9, the second layer 52 of the antireflection film 50 has a portion whose film thickness is adjusted for each pitch of the plurality of high refractive index portions 43b.

Furthermore, in Modification 9, the second layer 52 having an adjusted film thickness is arranged for each circular region overlapping one high refractive index portion 43b. That is, in Modification 9, the second layer 52 and the corresponding high refractive index portion 43b have the same shape in plan view.

With this configuration, the antireflection films 50 further optimized according to the effective refractive indexes of the color splitters 43R, 43G, and 43B can be configured. Therefore, according to Modification 9, the amount of light incident on the inside of the pixel array unit 10 can be further increased, and thus the sensitivity of the solid-state imaging element 1 can be further improved.

<Modification 10>

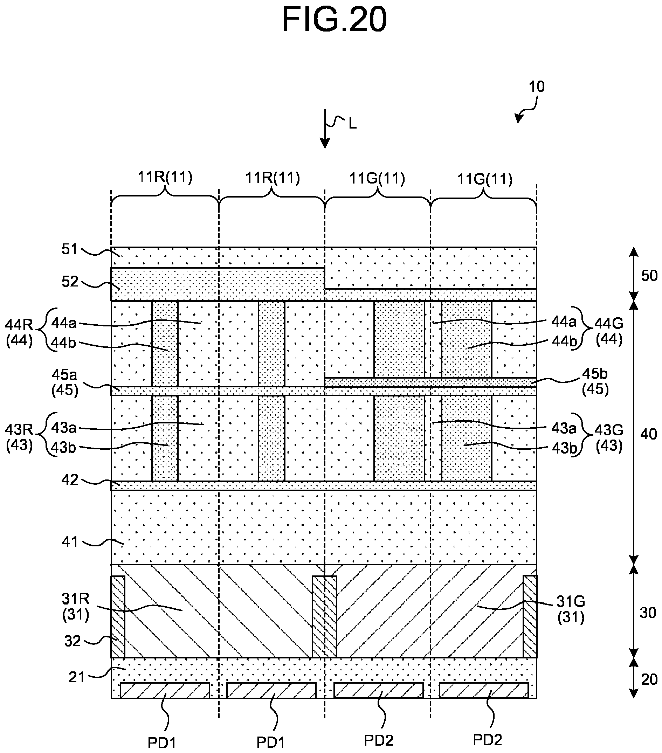

FIG. 20 is a cross-sectional view schematically illustrating a structure of a pixel array unit 10 according to Modification 10 of the embodiment of the present disclosure. In the pixel array unit 10 according to Modification 10, the configuration of the spectral layer 40 is different from that of the above-described embodiment.

Specifically, in Modification 10, the color splitter layer 44 is provided on the light incident side of the color splitter layer 43. The color splitter layer 44 is an example of another color splitter layer.

The color splitter layer 44 includes a low refractive index layer 44a and a plurality of high refractive index portions 44b. The low refractive index layer 44a includes a material having a refractive index lower than that of the high refractive index portion 44b. The high refractive index portion 44b having a predetermined shape (for example, a column shape) is provided inside the low refractive index layer 44a.

The high refractive index portion 44b includes a material having a refractive index higher than that of the low refractive index layer 44a. The low refractive index layer 44a and the high refractive index portion 44b include, for example, respective materials similar to those of the low refractive index layer 43a and the high refractive index portion 43b of the color splitter layer 43.

In the color splitter layer 44, a plurality of color splitters 44R, 44G, and 44B including the high refractive index portion 44b and the low refractive index layer 44a adjacent to such a high refractive index portion 44b is arranged.

The color splitter 44R is arranged on the light incident side of a pixel block in which the pixels 11R are arranged in a $2 \times 2$ lattice pattern. The color splitter 44G is arranged on the light incident side of a pixel block in which the pixels 11G are arranged in a $2 \times 2$ lattice pattern. The color splitter 44B is arranged on the light incident side of a pixel block in which the pixels 11B are arranged in a 2 × 2 lattice pattern.

As described above, in Modification 10, by providing the plurality of color splitter layers 43 and 44 having the meta-surface structure, the light of the corresponding color can be efficiently incident not only from immediately above but also from the adjacent region. Therefore, according to Modification 10, the sensitivity of the solid-state imaging element 1 can be further improved.

Further, in Modification 10, the stopper film 45 is arranged between the color splitter layer 43 and the color splitter layer 44. Such a stopper film 45 functions as an etching stopper when a recess corresponding to a columnar high refractive index portion 44b is formed inside the low refractive index layer 44a in the formation process of the color splitter layer 44.

The stopper film 45 includes, for example, a silicon compound such as silicon nitride or silicon carbide, a metal oxide such as titanium oxide, tantalum oxide, niobium oxide, hafnium oxide, indium oxide, or tin oxide, or a composite oxide thereof.

Then, in Modification 10, as illustrated in FIG. 20, the stopper films 45 located on the light incident side of the photodiodes PD1, PD2, and PD3 may have configurations different from each other.

For example, in the modification 10, the stopper film 45 located on the light incident side of the photodiode PD1 includes a first layer 45a, whereas the stopper film 45 located on the light incident side of the photodiode PD2 includes the first layer 45a and a second layer 45b.

In this manner, by arranging the stopper film 45 having different configurations on lower surfaces of the color splitters 44R, 44G, and 44B, the amount of light incident on the photodiodes PD1 to PD3 can be increased. Therefore, according to Modification 10, the sensitivity of the solid-state imaging element 1 can be further improved.

<Modification 11>

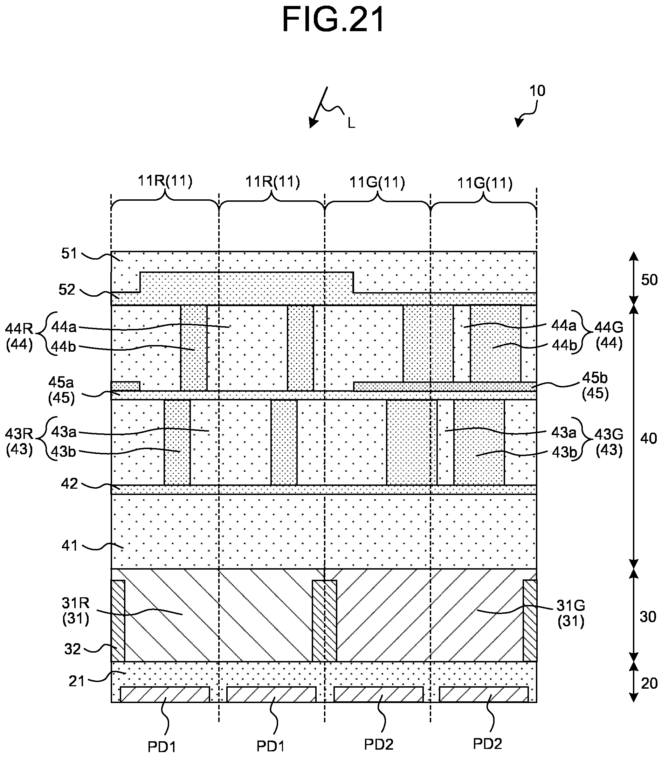

FIG. 21 is a cross-sectional view schematically illustrating a structure of a pixel array unit 10 according to Modification 11 of the embodiment of the present disclosure. As illustrated in FIG. 21, the relative positional relationship between the color splitters 43R, 43G, and 43B and the color splitters 44R, 44G, and 44B in each pixel 11 may be adjusted according to, for example, the distance (image height) from a center of the pixel array unit 10 (what is called pupil correction).

With this configuration, in each pixel 11 having different image heights in the pixel array unit 10, the incident light L can be substantially uniformly incident on the photodiodes PD1 to PD3. Therefore, according to Modification 11, the sensitivity of the solid-state imaging element 1 can be further improved.

Note that, in the embodiment and various modifications described so far, an example in which the pixel array unit 10 is configured by the four-divided Bayer RGB array has been described but the present disclosure is not limited to such an example, and the pixel array unit 10 may be configured by other RGB arrays.

In addition, in the above-described embodiment and various modifications, while an example in which red light, green light, and blue light are photoelectrically converted by the photodiodes PD1 to PD3 has been described, the present disclosure is not limited to such an example, and light in other wavelength ranges may be photoelectrically converted by the photodiodes PD1 to PD3.

[Effects]

The photodetection element (solid-state imaging element 1) according to the embodiment includes a first photoelectric conversion unit (photodiode PD1), a second photoelectric conversion unit (photodiode PD2), a third photoelectric conversion unit (photodiode PD3), a color splitter layer 43, and an antireflection film 50. The first photoelectric conversion unit (photodiode PD1) photoelectrically converts light in a first wavelength range. The second photoelectric conversion unit (photodiode PD2) is arranged side by side with the first photoelectric conversion unit (photodiode PD1), and photoelectrically converts light in a second wavelength range different from the first wavelength range. The third photoelectric conversion unit (photodiode PD3) is arranged side by side with the first photoelectric conversion unit (photodiode PD1) and the second photoelectric conversion unit (photodiode PD2), and photoelectrically converts light in a third wavelength range different from the first wavelength range and the second wavelength range. The color splitter layer 43 is arranged on the light incident side of the first photoelectric conversion unit (photodiode PD1), the second photoelectric conversion unit (photodiode PD2), and the third photoelectric conversion unit (photodiode PD3). The antireflection film 50 is arranged on the light incident side of the color splitter layer 43. Further, the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit have respective different configurations.

With this configuration, the sensitivity of the solid-state imaging element 1 can be improved.

Further, in the photodetection element (solid-state imaging element 1) according to the embodiment, the color splitter layer 43 has a meta-surface structure.

With this configuration, the sensitivity of the solid-state imaging element 1 can be improved.

Furthermore, in the photodetection element (solid-state imaging element 1) according to the embodiment, the antireflection film 50 includes the first layer 51 and the second layer 52 having different refractive indexes. Further, the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit have different respective film thicknesses of the first layer 51 and the second layer 52.

With this configuration, the sensitivity of the solid-state imaging element 1 can be easily improved.

Furthermore, in the photodetection element (solid-state imaging element 1) according to the embodiment, at least one of the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit does not include the first layer 51 or the second layer 52.

With this configuration, the sensitivity of the solid-state imaging element 1 can be improved.

Furthermore, in the photodetection element (solid-state imaging element 1) according to the embodiment, at least one of the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit is different from another of the antireflection films 50 in total film thickness of the first layer 51 and the second layer 52.

With this configuration, the sensitivity of the solid-state imaging element 1 can be further improved.

Furthermore, in the photodetection element (solid-state imaging element 1) according to the embodiment, the antireflection film 50 includes the first layer 51, the second layer 52, and the third layer 53 having different refractive indexes. Further, the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit have different respective film thicknesses of the first layer 51, the second layer 52, and the third layer 53.

With this configuration, the sensitivity of the solid-state imaging element 1 can be further improved.

Furthermore, in the photodetection element (solid-state imaging element 1) according to the embodiment, at least one of the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit does not have at least one of the first layer 51, the second layer 52, and the third layer 53.

With this configuration, the sensitivity of the solid-state imaging element 1 can be improved.

Furthermore, in the photodetection element (solid-state imaging element 1) according to the embodiment, at least one of the antireflection film 50 arranged on the light incident side of the first photoelectric conversion unit, the antireflection film 50 arranged on the light incident side of the second photoelectric conversion unit, and the antireflection film 50 arranged on the light incident side of the third photoelectric conversion unit is different from another of the antireflection films 50 in total film thickness of the first layer 51, the second layer 52, and the third layer 53.

With this configuration, the sensitivity of the solid-state imaging element 1 can be further improved.

Furthermore, in the photodetection element (solid-state imaging element 1) according to the embodiment, the color splitter layer 43 includes a plurality of high refractive index portions 43b arranged side by side at equal intervals and having a columnar shape. Further, the antireflection film 50 has a portion whose film thickness is adjusted for each pitch of the plurality of high refractive index portions 43b.

With this configuration, the sensitivity of the solid-state imaging element 1 can be further improved.

Furthermore, in the photodetection element (solid-state imaging element 1) according to the embodiment, the portion has the same shape as the corresponding high refractive index portion 43b in a plan view.

With this configuration, the sensitivity of the solid-state imaging element 1 can be further improved.

Furthermore, the photodetection element (solid-state imaging element 1) according to the embodiment further includes a stopper film 42 arranged on the side opposite to the light incident side with respect to the color splitter layer 43. Further, the stopper film 42 arranged on the light incident side of the first photoelectric conversion unit, the stopper film 42 arranged on the light incident side of the second photoelectric conversion unit, and the stopper film 42 arranged on the light incident side of the third photoelectric conversion unit have different respective configurations.

With this configuration, the sensitivity of the solid-state imaging element 1 can be further improved.

Furthermore, in the photodetection element (solid-state imaging element 1) according to the embodiment, the stopper film 42 arranged on the light incident side of the first photoelectric conversion unit, the stopper film 42 arranged on the light incident side of the second photoelectric conversion unit, and the stopper film 42 arranged on the light incident side of the third photoelectric conversion unit have different respective film thicknesses.

With this configuration, the sensitivity of the solid-state imaging element 1 can be easily improved.

Furthermore, in the photodetection element (solid-state imaging element 1) according to the embodiment, at least one of the stopper film 42 arranged on the light incident side of the first photoelectric conversion unit, the stopper film 42 arranged on the light incident side of the second photoelectric conversion unit, and the stopper film 42 arranged on the light incident side of the third photoelectric conversion unit has a film composition different another of the stopper films 42.

With this configuration, the sensitivity of the solid-state imaging element 1 can be further improved.

Furthermore, the photodetection element (solid-state imaging element 1) according to the embodiment further includes another color splitter layer 44 arranged on the light incident side of the color splitter layer 43, and another stopper film 45 arranged between the color splitter layer 43 and another color splitter layer 44. Further, another stopper film 45 arranged on the light incident side of the first photoelectric conversion unit, another stopper film 45 arranged on the light incident side of the second photoelectric conversion unit, and another stopper film 45 arranged on the light incident side of the third photoelectric conversion unit have different configurations.

With this configuration, the sensitivity of the solid-state imaging element 1 can be further improved.

Furthermore, in the photodetection element (solid-state imaging element 1) according to the embodiment, the color splitter layer 43 and another color splitter layer 44 are formed in a shape subjected to pupil correction according to the image height.

With this configuration, the sensitivity of the solid-state imaging element 1 can be further improved.

[Electronic device]

Note that the present disclosure is not limited to application to a solid-state imaging element. That is, the present disclosure is applicable to all electronic devices having a solid-state imaging element, such as a camera module, an imaging device, a mobile terminal device having an imaging function, or a copying machine using a solid-state imaging element in an image reading unit, in addition to the solid-state imaging element.

Examples of such an imaging device include a digital still camera and a video camera. Examples of the mobile terminal device having such an imaging function include a smartphone and a tablet terminal.

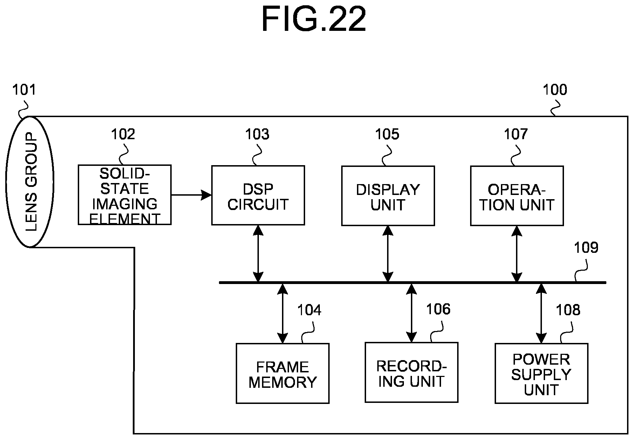

FIG. 22 is a block diagram illustrating a configuration example of an imaging device as a electronic device 100 to which the technology according to the present disclosure is applied. An electronic device 100 in FIG. 22 is, for example, an electronic device such as an imaging device such as a digital still camera or a video camera, or a mobile terminal device such as a smartphone or a tablet terminal.

In FIG. 22, an electronic device 100 includes a lens group 101, a solid-state imaging element 102, a DSP circuit 103, a frame memory 104, a display unit 105, a recording unit 106, an operation unit 107, and a power supply unit 108.

Furthermore, in the electronic device 100, the DSP circuit 103, the frame memory 104, the display unit 105, the recording unit 106, the operation unit 107, and the power supply unit 108 are mutually connected via a bus line 109.

The lens group 101 captures incident light (image light) from a subject and forms an image on an imaging surface of the solid-state imaging element 102. The solid-state imaging element 102 corresponds to the solid-state imaging element 1 according to the above-described embodiment, and converts the amount of incident light imaged on the imaging surface by the lens group 101 into an electrical signal in units of pixels and outputs the electrical signal as a pixel signal.

The DSP circuit 103 is a camera signal processing circuit that processes a signal supplied from the solid-state imaging element 102. The frame memory 104 temporarily holds the image data processed by the DSP circuit 103 in units of frames.

The display unit 105 includes, for example, a panel type display device such as a liquid crystal panel or an organic electro luminescence (EL) panel, and displays a moving image or a still image captured by the solid-state imaging element 102. The recording unit 106 records image data of a moving image or a still image captured by the solid-state imaging element 102 on a recording medium such as a semiconductor memory or a hard disk.

The operation unit 107 issues operation commands for various functions of the electronic device 100 in accordance with an operation by a user. The power supply unit 108 appropriately supplies various power sources to be operation power sources of the DSP circuit 103, the frame memory 104, the display unit 105, the recording unit 106, and the operation unit 107 to these supply targets.

In the electronic device 100 configured as described above, the sensitivity of the solid-state imaging element 102 can be improved by applying the solid-state imaging element 1 of each of the above-described embodiments as the solid-state imaging element 102.

Although the embodiments of the present disclosure have been described above, the technical scope of the present disclosure is not limited to the above-described embodiments as it is, and various modifications can be made without departing from the gist of the present disclosure. In addition, components of different embodiments and modification examples may be appropriately combined.

In addition, the effects described in the present specification are merely examples and are not limited, and other effects may be provided.

Note that the present technology can also have the following configurations.

(1) A photodetection element comprising:

a first photoelectric conversion unit that photoelectrically converts light in a first wavelength range;
a second photoelectric conversion unit that is arranged side by side with the first photoelectric conversion unit and photoelectrically converts light in a second wavelength range different from the first wavelength range;
a third photoelectric conversion unit that is arranged side by side with the first photoelectric conversion unit and the second photoelectric conversion unit and photoelectrically converts light in a third wavelength range different from the first wavelength range and the second wavelength range;
a color splitter layer arranged on a light incident side of the first photoelectric conversion unit, the second photoelectric conversion unit, and the third photoelectric conversion unit; and
an antireflection film arranged on a light incident side of the color splitter layer, wherein
the antireflection film arranged on the light incident side of the first photoelectric conversion unit, the antireflection film arranged on a light incident side of the second photoelectric conversion unit, and the antireflection film arranged on a light incident side of the third photoelectric conversion unit have different respective configurations.

(2) The photodetection element according to the above (1), wherein
the color splitter layer has a meta-surface structure.
(3) The photodetection element according to the above (1) or (2), wherein

the antireflection film includes a first layer and a second layer having different refractive indexes, and
the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer and the second layer.

(4) The photodetection element according to the above (3), wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not include the first layer or the second layer.
(5) The photodetection element according to the above (3) or (4), wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer and the second layer.
(6) The photodetection element according to the above (1) or (2), wherein

the antireflection film includes a first layer, a second layer, and a third layer having different refractive indexes, and
the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer, the second layer, and the third layer.

(7) The photodetection element according to the above (6), wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not have at least one of the first layer, the second layer, and the third layer.
(8). The photodetection element according to the above (6) or (7), wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer, the second layer, and the third layer.
(9) The photodetection element according to the above (1) or (2), wherein

the color splitter layer includes a plurality of high refractive index portions arranged side by side at equal intervals and having a columnar shape, and
the antireflection film has a portion whose film thickness is adjusted for each pitch of the plurality of high refractive index portions.

(10) The photodetection element according to the above (9), wherein
the portion has the same shape as the corresponding high refractive index portion in a plan view.
(11) The photodetection element according to any one of the above (1) to (10), further comprising:

a stopper film arranged on a side opposite to a light incident side with respect to the color splitter layer, wherein
the stopper film arranged on the light incident side of the first photoelectric conversion unit, the stopper film arranged on the light incident side of the second photoelectric conversion unit, and the stopper film arranged on the light incident side of the third photoelectric conversion unit have different respective configurations.

(12) The photodetection element according to the above (11), wherein
the stopper film arranged on the light incident side of the first photoelectric conversion unit, the stopper film arranged on the light incident side of the second photoelectric conversion unit, and the stopper film arranged on the light incident side of the third photoelectric conversion unit have different respective film thicknesses.
(13) The photodetection element according to the above (11) or (12), wherein
at least one of the stopper film arranged on the light incident side of the first photoelectric conversion unit, the stopper film arranged on the light incident side of the second photoelectric conversion unit, and the stopper film arranged on the light incident side of the third photoelectric conversion unit has a film composition different from another of the stopper films.
(14) The photodetection element according to any one of the above (11) to (13), further comprising:

another color splitter layer arranged on a light incident side of the color splitter layer; and
another stopper film arranged between the color splitter layer and the another color splitter layer, wherein
the another stopper film arranged on the light incident side of the first photoelectric conversion unit, the another stopper film arranged on the light incident side of the second photoelectric conversion unit, and the another stopper film arranged on the light incident side of the third photoelectric conversion unit have different configurations.

(15) The photodetection element according to the above (14), wherein
the color splitter layer and the another color splitter layer are formed in a pupil-corrected shape according to an image height.
(16) An electronic device comprising:

a photodetection element;
an optical system that captures incident light from an object to be detected and forms an image on a photodetection element surface of the photodetection element; and
a signal processing circuit that performs processing on an output signal from the photodetection element, wherein
the photodetection element includes
a first photoelectric conversion unit that photoelectrically converts light in a first wavelength range,
a second photoelectric conversion unit that is arranged side by side with the first photoelectric conversion unit and photoelectrically converts light in a second wavelength range different from the first wavelength range,
a third photoelectric conversion unit that is arranged side by side with the first photoelectric conversion unit and the second photoelectric conversion unit and photoelectrically converts light in a third wavelength range different from the first wavelength range and the second wavelength range,
a color splitter layer arranged on a light incident side of the first photoelectric conversion unit, the second photoelectric conversion unit, and the third photoelectric conversion unit, and
an antireflection film arranged on a light incident side of the color splitter layer, and
the antireflection film arranged on the light incident side of the first photoelectric conversion unit, the antireflection film arranged on the light incident side of the second photoelectric conversion unit, and the antireflection film arranged on a light incident side of the third photoelectric conversion unit have different respective configurations.

(17) The electronic device according to the above (16), wherein
the color splitter layer has a meta-surface structure.
(18) The electronic device according to the above (16) or (17), wherein

the antireflection film includes a first layer and a second layer having different refractive indexes, and

the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer and the second layer.

(19) The electronic device according to the above (18), wherein

at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not include the first layer or the second layer.

(20) The electronic device according to the above (18) or (19), wherein

at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer and the second layer.

(21) The electronic device according to the above (16) or (17), wherein

the antireflection film includes a first layer, a second layer, and a third layer having different refractive indexes, and

the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer, the second layer, and the third layer.

(22) The electronic device according to the above (21), wherein

at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not have at least one of the first layer, the second layer, and the third layer.

(23) The electronic device according to the above (21) or (22), wherein

at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer, the second layer, and the third layer.

(24) The electronic device according to the above (16) or (17), wherein

the color splitter layer includes a plurality of high refractive index portions arranged side by side at equal intervals and having a columnar shape, and

the antireflection film has a portion whose film thickness is adjusted for each pitch of the plurality of high refractive index portions.

(25) The electronic device according to the above (24), wherein

the portion has the same shape as the corresponding high refractive index portion in a plan view.

(26) The electronic device according to any one of the above (16) to (25), wherein

the photodetection element further includes

a stopper film arranged on a side opposite to a light incident side with respect to the color splitter layer, wherein the stopper film arranged on the light incident side of the first photoelectric conversion unit, the stopper film arranged on the light incident side of the second photoelectric conversion unit, and the stopper film arranged on the light incident side of the third photoelectric conversion unit have different respective configurations.

(27) The electronic device according to the above (26), wherein

the stopper film arranged on the light incident side of the first photoelectric conversion unit, the stopper film arranged on the light incident side of the second photoelectric conversion unit, and the stopper film arranged on the light incident side of the third photoelectric conversion unit have different respective film thicknesses.

(28) The electronic device according to the above (26) or (27), wherein

at least one of the stopper film arranged on the light incident side of the first photoelectric conversion unit, the stopper film arranged on the light incident side of the second photoelectric conversion unit, and the stopper film arranged on the light incident side of the third photoelectric conversion unit has a film composition different from another of the stopper films.

(29) The electronic device according to any one of the above (26) to (28), wherein

the photodetection element further includes
another color splitter layer arranged on a light incident side of the color splitter layer; and
another stopper film arranged between the color splitter layer and the another color splitter layer, wherein
the another stopper film arranged on the light incident side of the first photoelectric conversion unit, the another stopper film arranged on the light incident side of the second photoelectric conversion unit, and the another stopper film arranged on the light incident side of the third photoelectric conversion unit have different configurations.

(30) The electronic device according to the above (29), wherein
the color splitter layer and the another color splitter layer are formed in a pupil-corrected shape according to an image height. Reference Signs List

1 SOLID-STATE IMAGING ELEMENT (EXAMPLE OF PHOTODETECTION ELEMENT)
10 PIXEL ARRAY UNIT
40 SPECTRAL LAYER
42 STOPPER FILM
43 COLOR SPLITTER LAYER
43R, 43G, 43B COLOR SPLITTER
44 COLOR SPLITTER LAYER (EXAMPLE OF ANOTHER COLOR SPLITTER LAYER)
45 STOPPER FILM (EXAMPLE OF ANOTHER STOPPER FILM)
50 ANTIREFLECTION FILM
51 FIRST LAYER
52 SECOND LAYER
53 THIRD LAYER
100 ELECTRONIC DEVICE
PD1 PHOTODIODE (EXAMPLE OF FIRST PHOTOELECTRIC CONVERSION UNIT)
PD2 PHOTODIODE (EXAMPLE OF SECOND PHOTOELECTRIC CONVERSION UNIT)
PD3 PHOTODIODE (EXAMPLE OF THIRD PHOTOELECTRIC CONVERSION UNIT)

**Claims**

1. A photodetection element comprising:

a first photoelectric conversion unit that photoelectrically converts light in a first wavelength range;
a second photoelectric conversion unit that is arranged side by side with the first photoelectric conversion unit and photoelectrically converts light in a second wavelength range different from the first wavelength range;
a third photoelectric conversion unit that is arranged side by side with the first photoelectric conversion unit and the second photoelectric conversion unit and photoelectrically converts light in a third wavelength range different from the first wavelength range and the second wavelength range;
a color splitter layer arranged on a light incident side of the first photoelectric conversion unit, the second photoelectric conversion unit, and the third photoelectric conversion unit; and
an antireflection film arranged on a light incident side of the color splitter layer, wherein
the antireflection film arranged on the light incident side of the first photoelectric conversion unit, the antireflection film arranged on a light incident side of the second photoelectric conversion unit, and the antireflection film arranged on a light incident side of the third photoelectric conversion unit have different respective configurations.

2. The photodetection element according to claim 1, wherein
the color splitter layer has a meta-surface structure.

3. The photodetection element according to claim 1, wherein

the antireflection film includes a first layer and a second layer having different refractive indexes, and
the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer and the second layer.

4. The photodetection element according to claim 3, wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not include the first layer or the second layer.

5. The photodetection element according to claim 3, wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer and the second layer.

6. The photodetection element according to claim 1, wherein

the antireflection film includes a first layer, a second layer, and a third layer having different refractive indexes, and
the antireflection film arranged on the light incident side of the first photoelectric conversion unit, the antireflection film arranged on the light incident side of the second photoelectric conversion unit, and the antireflection film arranged on the light incident side of the third photoelectric conversion unit have different respective film thicknesses of the first layer, the second layer, and the third layer.

7. The photodetection element according to claim 6, wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit does not have at least one of the first layer, the second layer, and the third layer.

8. The photodetection element according to claim 6, wherein
at least one of the antireflection film arranged on the light incident side of the first photoelectric conversion unit, the antireflection film arranged on the light incident side of the second photoelectric conversion unit, and the antireflection film arranged on the light incident side of the third photoelectric conversion unit is different from another of the antireflection films in total film thickness of the first layer, the second layer, and the third layer.

9. The photodetection element according to claim 1, wherein

the color splitter layer includes a plurality of high refractive index portions arranged side by side at equal intervals and having a columnar shape, and
the antireflection film has a portion whose film thickness is adjusted for each pitch of the plurality of high refractive index portions.

10. The photodetection element according to claim 9, wherein
the portion has the same shape as the corresponding high refractive index portion in a plan view.

11. The photodetection element according to claim 1, further comprising:

a stopper film arranged on a side opposite to a light incident side with respect to the color splitter layer, wherein
the stopper film arranged on the light incident side of the first photoelectric conversion unit, the stopper film arranged on the light incident side of the second photoelectric conversion unit, and the stopper film arranged on the light incident side of the third photoelectric conversion unit have different respective configurations.

12. The photodetection element according to claim 11, wherein
the stopper film arranged on the light incident side of the first photoelectric conversion unit, the stopper film arranged on the light incident side of the second photoelectric conversion unit, and the stopper film arranged on the light incident side of the third photoelectric conversion unit have different respective film thicknesses.

13. The photodetection element according to claim 11, wherein
at least one of the stopper film arranged on the light incident side of the first photoelectric conversion unit, the stopper film arranged on the light incident side of the second photoelectric conversion unit, and the stopper film arranged on the light incident side of the third photoelectric conversion unit has a film composition different from another of the stopper films.

14. The photodetection element according to claim 11, further comprising:

another color splitter layer arranged on a light incident side of the color splitter layer; and
another stopper film arranged between the color splitter layer and the another color splitter layer, wherein
the another stopper film arranged on the light incident side of the first photoelectric conversion unit, the another stopper film arranged on the light incident side of the second photoelectric conversion unit, and the another stopper film arranged on the light incident side of the third photoelectric conversion unit have different configurations.

15. The photodetection element according to claim 14, wherein
the color splitter layer and the another color splitter layer are formed in a pupil-corrected shape according to an image height.

16. An electronic device comprising:

a photodetection element;
an optical system that captures incident light from an object to be detected and forms an image on a photodetection element surface of the photodetection element; and
a signal processing circuit that performs processing on an output signal from the photodetection element, wherein
the photodetection element includes
a first photoelectric conversion unit that photoelectrically converts light in a first wavelength range,
a second photoelectric conversion unit that is arranged side by side with the first photoelectric conversion unit and photoelectrically converts light in a second wavelength range different from the first wavelength range,
a third photoelectric conversion unit that is arranged side by side with the first photoelectric conversion unit and the second photoelectric conversion unit and photoelectrically converts light in a third wavelength range different from the first wavelength range and the second wavelength range,
a color splitter layer arranged on a light incident side of the first photoelectric conversion unit, the second photoelectric conversion unit, and the third photoelectric conversion unit, and
an antireflection film arranged on a light incident side of the color splitter layer, and
the antireflection film arranged on the light incident side of the first photoelectric conversion unit, the antireflection film arranged on the light incident side of the second photoelectric conversion unit, and the antireflection film arranged on a light incident side of the third photoelectric conversion unit have different respective configurations.

# FIG.1

# FIG.2

# FIG.3

# FIG.4

# FIG.5

R2  R1  43R(43G,43B)

L

$n_{R2}$  $n_{R1}$

X

43b  43a

$\theta$

# FIG.6

# FIG.7

# FIG.8

# FIG.9

# FIG.10

# FIG.11

# FIG.12

# FIG.13

# FIG.14

# FIG.15

# FIG.16

# FIG.17

# FIG.18

# FIG.19

# FIG.20

# FIG.21

# FIG.22

## INTERNATIONAL SEARCH REPORT

International application No.

**PCT/JP2023/008238**

### A. CLASSIFICATION OF SUBJECT MATTER

*G01J 1/02*(2006.01)i; *G01J 1/04*(2006.01)i; *H01L 27/146*(2006.01)i; *H01L 31/0232*(2014.01)i; *H01L 31/10*(2006.01)i; *H05B 33/02*(2006.01)i; *H10K 50/00*(2023.01)i; *H10K 59/00*(2023.01)i

FI: H01L27/146 D; H10K59/00; H05B33/02; H05B33/14 A; G01J1/02 Q; G01J1/04 B; H01L31/10 D; H01L31/02 D

According to International Patent Classification (IPC) or to both national classification and IPC

### B. FIELDS SEARCHED

Minimum documentation searched (classification system followed by classification symbols)

G01J1/02; G01J1/04; H01L27/146; H01L31/0232; H01L31/10; H05B33/02; H10K50/00; H10K59/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2010-027875 A (PANASONIC CORP.) 04 February 2010 (2010-02-04) paragraphs [0035]-[0094], fig. 1, 19 | 1-8, 16 |
| Y | WO 2015/170629 A1 (SONY CORP.) 12 November 2015 (2015-11-12) paragraphs [0033]-[0044], fig. 3 | 1-8, 16 |
| Y | JP 2021-150615 A (SONY SEMICONDUCTOR SOLUTIONS CORP.) 27 September 2021 (2021-09-27) paragraph [0093] | 2 |
| A | US 2017/0170220 A1 (SAMSUNG ELECTRONICS CO., LTD.) 15 June 2017 (2017-06-15) paragraphs [0070]-[0074], fig. 8 | 1-16 |
| A | WO 2006/028128 A1 (MATSUSHITA ELECTRIC INDUSTRIAL CO., LTD.) 16 March 2006 (2006-03-16) paragraphs [0024]-[0054], fig. 7 | 1-16 |

☐ Further documents are listed in the continuation of Box C.　☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **16 May 2023** | **23 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2023/008238**

| Patent document cited in search report | | | Publication date (day/month/year) | Patent family member(s) | | | Publication date (day/month/year) |
|---|---|---|---|---|---|---|---|
| JP | 2010-027875 | A | 04 February 2010 | (Family: none) | | | |
| WO | 2015/170629 | A1 | 12 November 2015 | US | 2017/0045644 | A1 | |
| | | | | paragraphs [0044]-[0055], fig. 3 | | | |
| | | | | CN | 106537593 | A | |
| JP | 2021-150615 | A | 27 September 2021 | WO | 2021/192677 | A1 | |
| US | 2017/0170220 | A1 | 15 June 2017 | KR | 10-2017-0070685 | A | |
| WO | 2006/028128 | A1 | 16 March 2006 | US | 2008/0265349 | A1 | |
| | | | | paragraphs [0089]-[0153], fig. 7 | | | |
| | | | | EP | 1816677 | A1 | |
| | | | | KR | 10-2007-0061530 | A | |
| | | | | CN | 101015062 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021140152 A